(19) Europäisches Patentamt
European Patent Office
Office européen des brevets

(11) **EP 2 116 856 B1**

(12) **EUROPÄISCHE PATENTSCHRIFT**

(45) Veröffentlichungstag und Bekanntmachung des Hinweises auf die Patenterteilung:
**15.08.2018   Patentblatt 2018/33**

(51) Int Cl.:
*G01R 19/00* *(2006.01)*          *H02M 1/00* *(2006.01)*
*H02M 7/5387* *(2007.01)*      *G01R 25/00* *(2006.01)*

(21) Anmeldenummer: **09100170.1**

(22) Anmeldetag: **10.03.2009**

(54) **Verfahren zur Fehlerkorrektur bei einer Strommessung in einem mehrphasigen Stromnetz**

Method for correcting errors in an electricity measurement in a multi-phase electricity network

Procédé de correction des erreurs lors de la mesure de courant dans un secteur multiphasé

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(30) Priorität: **06.05.2008   DE 102008001586**

(43) Veröffentlichungstag der Anmeldung:
**11.11.2009   Patentblatt 2009/46**

(73) Patentinhaber: **ROBERT BOSCH GMBH**
**70442 Stuttgart (DE)**

(72) Erfinder:
• **Finke, Sven**
**70839 Gerlingen (DE)**
• **Kuehn, Timo**
**76307 Karlsbad (DE)**

(56) Entgegenhaltungen:
**DE-A1- 4 013 089          JP-A- 2004 135 441**
**US-A- 5 436 819          US-A1- 2004 169 488**
**US-A1- 2007 090 785**

• **BLAABJERG F ET AL: "An ideal PWM-VSI inverter using only one current sensor in the DC-link", 19940101, 1. Januar 1994 (1994-01-01), Seiten 458-464, XP006511326,**

## Beschreibung

Die Erfindung betrifft ein Verfahren zur Strommessung von Phasenströmen mittels einer Messschaltung in einem mehrphasigen Stromnetz, in dem durch mindestens ein steuerbares Schaltelement eine gewünschte Bestromung mindestens eines elektrischen Verbrauchers erfolgt und auf das Schaltelement Steuersignale wirken, um die gewünschte Bestromung des Verbrauchers zu erreichen, wobei Taktmustern der Ansteuersignale Messfenster für die Strommessung zugeordnet sind und Taktmuster für eine gewünschte Messfenstergröße und/oder -position zeitlich verschoben werden, wobei bei der Strommessung mindestens ein Stromwerte aufweisender Messstromverlauf gemessen wird, der aufgrund der verschobenen Taktmuster mindestens einen Fehler aufweist, wobei aus dem Messstromverlauf ein Stromwerte aufweisender Phasenstromverlauf ermittelt wird, bei dem der Fehler mindestens eine Sprungstelle bewirkt.

## Stand der Technik

Bei Elektromotoren mit mehrphasiger Ansteuerung besteht oft der Wunsch, die Phasenströme zu erfassen. Handelt es sich um eine Bestromung eines Elektromotors mittels einer steuerbaren Brücke, die in ihren einzelnen Brückenzweigen steuerbare Schaltelemente aufweist, so lässt sich der Elektromotor in gewünschter Weise bestromen. Zu diesem Zweck werden die Schaltelemente mit Taktmustern angesteuert, die beispielsweise auf Basis einer mittenzentrierten Pulsweitenmodulation erzeugt werden. Um die Phasenströme zu erfassen, wird in jeder Phasenleitung ein niederohmiger Widerstand (Shunt) angeordnet. Der Aufwand dieser mehrphasigen Messanordnung ist entsprechend groß. Um den Aufwand zu verkleinern, kann ein einzelner Shunt in eine gemeinsame Leitung gelegt werden, mit der jede Phasenleitung verbunden ist. Werden dann die Ansteuersignale der Schaltelemente derart zueinander verschoben, sodass die Schaltelemente sequenziell geschaltet werden, bilden sich zwischen den einzelnen Schaltungen der Schaltelemente Messfenster, innerhalb derer Messungen durchgeführt werden können. Die nacheinander durchgeführten Messungen ergeben Stromwerte unterschiedlicher Messstromverläufe. Diese ermöglichen einen Rückschluss auf die Phasenströme der einzelnen Phasen, wobei die einzelnen Messstromverläufe analysiert werden müssen, um die Phasenstromverläufe ermitteln zu können. Durch das Verschieben der Ansteuersignale bilden sich Blindstromanteile im Stromnetz, die bei Erfassung des Messstromverlaufs am Shunt einen Fehler bewirken. Bei der Analyse des Messstromverlaufs ergeben sich aufgrund des Fehlers in dem ermittelten Phasenstromverlauf Sprungstellen, wodurch der Phasenstromverlauf bereichsweise, nämlich von einem Sprung zu einem nächsten Sprung seinerseits eine Ungenauigkeit aufweist.

Die Ungenauigkeit wird im Stand der Technik bei Fertigungsende einer entsprechenden Baugruppe durch einmalige Kalibrierung beseitigt, dem Bandende-Abgleich. Eine weitere Berücksichtigung während einer Bauteillebensdauer erfolgt nicht, weshalb ein erneutes Auftreten der Ungenauigkeit nicht erkannt und korrigiert werden kann.

Das in der US 2004/169488 A1 beschriebene Verfahren betrifft ein Verfahren zur "1-Shunt-Strommessung". Mittels des dort offenbarten Verfahrens soll ein nicht messbarer Bereich bei der Strommessung überbrückt werden, wobei Stromverläufe kontinuierlich überprüft und bewertet werden, um optimale Abtastzeitpunkte der Strommessung ermitteln zu können. Es handelt sich dabei insofern um eine stochastische Methode zur Strommessung.

## Offenbarung der Erfindung

Der Erfindung liegt die Aufgabe zugrunde, eine sehr einfache und kostengünstige Strommessung zu ermöglichen, wobei der Fehler stets korrekt korrigiert wird. Diese Aufgabe wird durch das erfindungsgemäße Verfahren nach dem Anspruch 1 gelöst.

Bei dem erfindungsgemäßen Verfahren ist vorgesehen, dass das Auftreten der Sprungstelle erfasst wird, dass die Sprunghöhe der Sprungstelle ermittelt wird und dass der Phasenstromverlauf in Abhängigkeit der Sprunghöhe derart korrigiert wird, dass der der Sprunghöhe entsprechende Stromwert im sich an die Sprungstelle anschließenden zeitlichen Verlauf von den Stromwerten des Messstromverlaufs zumindest teilweise abgezogen oder zu diesem zumindest teilweise addiert wird. Der Fehler bildet sich aufgrund von Blindstromanteilen durch die Taktverschiebung der Ansteuersignale, insbesondere dann, wenn die Ströme über einen elektrischen Knoten miteinander in Wechselwirkung stehen. Dieses Ungleichgewicht an dem Knoten führt zu Blindströmen, die die Strommessung und damit den Messstromverlauf mit dem Fehler behaften. Das Verfahren ermöglicht eine automatische und adaptive Korrektur der durch die Sprungstellen erzeugten Ungenauigkeiten in dem Phasenstromverlauf, da jede Sprungstelle analysiert wird, und ihr Einfluss auf das Messergebnis korrigiert wird. Somit werden auch Temperatur- und Alterungseffekte, sowie unterschiedliche Einflüsse in verschiedenen Arbeitspunkten des elektrischen Verbrauchers stets berücksichtigt und ermöglichen somit eine hochgenaue Strommessung. In der Erfindung ist vorgesehen, dass das Stromnetz einen rotierenden Phasenvektor aufweist und dass aus dem Messstromverlauf ein Phasenstromverlauf ermittelt wird, indem die Stromwerte des Phasenstromverlaufs in Abhängigkeit eines Drehwinkels des Phasenvektors dem Messstromverlauf direkt entnommen werden und/oder aus Stromwerten mindestens eines Messstromverlaufs berechnet werden. Bei einer sequenziellen Strommessung enthält der Messstromverlauf entweder einen einzelnen Phasenstromverlauf oder eine Kombination mehrerer Phasenstromverläufe, ferner kann vorgesehen sein, dass mindestens ein Teil des Phasenstromverlaufs berechnet wird. Das Verfahren wird bevorzugt dann angewendet, wenn das Stromnetz mittels Pulsweitenmodulation durch die Schaltelemente betrieben wird. Dabei werden die Taktmuster in Abhängigkeit der Phasenlage des Phasenstromverlaufs verschoben, weshalb sich aus dem Drehwinkel, der die Phasenlage des Phasenstromverlaufs wiedergibt, der momentane Inhalt des Messstromverlaufs ableiten lässt. So ergibt sich aus einem bestimmten Drehwinkel, insbesondere einem Drehwinkelbereich, welchen Inhalt der Messstromverlauf aktuell führt. Anhand dieser Informationen kann der gewünschte Phasenstromverlauf entweder dem Messstromverlauf entnommen werden oder anhand elektrischer Gleichungen berechnet werden.

Nach einer Weiterbildung der Erfindung ist vorgesehen, dass das Auftreten der Sprungstelle erfasst wird, wenn innerhalb einer festgelegten Zeitspanne ein Anstieg und/oder ein Abfall der Stromwerte des Phasenstromverlaufs eines vorgegebenen Schwellwerts über- oder unterschreitet. Insbesondere bei bekanntem Phasenstromverlauf ist es vorteilhaft, wenn als Schwellwert ein maximaler Anstieg oder ein maximaler Abfall innerhalb einer bestimmten Zeitspanne angegeben wird. Wird dieser Schwellwert von dem Phasenstromverlauf nicht eingehalten, so kann von einer Sprungstelle ausgegangen werden.

Nach einer Weiterbildung des Verfahrens ist vorgesehen, dass das Auftreten der Sprungstelle erfasst wird, wenn eine Abweichung des Phasenstromverlaufs von einem berechneten und/oder abgeschätzt erwarteten Phasenstromverlauf auftritt und die Abweichung einen Schwellwert über- oder unterschreitet. Bei digitalen Messungen kann die Erfassung eines Sprunges mittels eines maximalen Anstiegs oder Abfalls von einem Messpunkt zum nächsten zu Fehlerfassungen führen, da der Verlauf zwischen den Messpunkten nicht erfasst wird. Dies ist insbesondere dann der Fall, wenn der Phasenvektor hohe Winkelgeschwindigkeiten aufweist und/oder hohe Stromamplituden betrachtet werden. Es ist daher sinnvoll, eine Abschätzung des nächsten zu erwartenden Stromwerts im Phasenstromverlauf vorzunehmen, um eine mögliche Abweichung des erfassten Stromwerts des Phasenstromverlaufs von dem erwarteten Stromwert auswerten zu können. Diese Auswertung kann wiederum über einen Schwellwert erfolgen. In der Erfindung ist vorgesehen, dass bei mindestens einem bestimmten Drehwinkel des Phasenvektors immer eine Sprungstelle auftritt und dass das Auftreten dieser Sprungstelle anhand des Drehwinkels erfasst wird. Wie bereits erwähnt, kann bei einem Stromnetz mit einem rotierenden Phasenvektor der Drehwinkel des Phasenvektors in Bereiche eingeteilt werden, in welchen der Phasenstromverlauf auf unterschiedliche Weise aus dem Messstromverlauf ermittelt wird. Eine Sprungstelle tritt insbesondere dann auf, wenn ein Übergang von einem solchen Drehwinkelbereich in einen anderen Drehwinkelbereich vollzogen wird, da dann von einer Weise des Ermittelns in eine nächste, andere Weise des Ermittelns gewechselt wird. Durch diesen Wechsel wird der Fehler in dem Messstromverlauf unterschiedlich berücksichtigt, wodurch Sprungstellen entstehen. Somit lassen sich derartig gebildete Sprungstellen anhand des Drehwinkels, insbesondere anhand des Übergangs des Drehwinkels von einem Drehwinkelbereich in einen nächsten Drehwinkelbereich einfach und schnell erfassen.

Nach einer Weiterbildung der Erfindung ist vorgesehen, dass der Messstromverlauf aufgrund von mindestens einem Bauteilestreuungs-, Temperatur- und/oder Alterungseffekt der Messschaltung mindestens einen über den Messstromverlauf weitgehend gleichförmigen Zusatzfehler aufweist, der im Phasenstromverlauf eine Veränderung der Sprunghöhe der Sprungstelle bewirkt, wobei mittels elektrischer Gleichungen des elektrischen Verbrauchers, insbesondere elektrische Maschinengleichung einer den elektrischen Verbraucher darstellenden elektrischen Maschine, und der Sprunghöhe der Stromwert der Veränderung berechnet wird, welcher von dem Messstromverlauf abgezogen oder zu diesem addiert wird. Derartige Effekte der Messschaltungen führen dazu, dass die Stromwerte des Messstromverlaufs alle weitgehend auf die gleiche Weise vergrößert oder verkleinert werden, also dass der Messstromverlauf im Gesamten verschoben wird. Da diese Verschiebung sich auf die einzelnen Sprunghöhen auswirkt, kann anhand der Sprunghöhe durch geeignete elektrische Gleichungen, wie elektrischen Gleichungen des elektrischen Verbrauchers, die Veränderung berechnet werden, welche ausschließlich aus einem oder mehreren der Effekte der Messschaltung entsteht. Auf diese Weise ist eine Kompensation derartiger Effekte möglich, was insgesamt eine hohe Adaptivität und Genauigkeit der Strommessung ermöglicht. Unter Bauteilestreuungseffekten werden Effekte verstanden, die in einzelnen Bauteilen der Schaltung, insbesondere der Messschaltung, aufgrund produktionsbedingter Abweichungen entstehen, beispielsweise durch Fertigungstoleranzen, aus denen eine Messabweichung und/oder ein Messrauschen hervorgeht.

Nach einer Weiterbildung des Verfahrens ist vorgesehen, dass der der Sprunghöhe entsprechende Stromwert und/oder der der Veränderung der Sprunghöhe entsprechende Stromwert des Phasenstromverlaufs von dem Messstromverlauf in einem bis zu einer weiteren, nachfolgenden Sprungstelle reichenden Zeitabschnitt unverändert abgezogen oder zum Messstromverlauf unverändert addiert wird/werden. Wird eine Sprungstelle erfasst und deren Sprunghöhe ermittelt, so wird der Phasenstromverlauf in Abhängigkeit dieser aktuellen Sprunghöhe korrigiert. Das Korrigieren wird solange anhand desselben Wertes, der sich in Abhängigkeit der aktuellen Sprunghöhe ergibt, vorgenommen, bis eine erneute Sprungstelle erfasst wird, wonach sich das Verfahren periodisch wiederholt. Eine Möglichkeit, den Phasenstromverlauf kontinuierlich auf diese Weise zu korrigieren, ergibt sich mittels einer Regelung, insbesondere einer Regelung mit einem proportionalen und einem integralen Anteil.

Es ist ferner denkbar, das Verfahren bei Systemen anzuwenden, welche einen nicht oder nur zeitweise rotierenden Phasenvektor aufweisen, in dem eine Umschaltung zwischen unterschiedlichen Weisen der Ermittlung des Phasenstromverlaufs, beispielsweise anhand erwarteter Stromwerte oder eines durch eine Steuerung vorgesehenen oder angenommenen Stromzustandes, ermittelt werden und somit auch für derartige Systeme eine adaptive Korrektur von Sprungstellen und insbesondere adaptive Korrektur von Temperatur- und/oder Alterungseffekten der Messschaltung zu ermöglichen.

**Kurze Beschreibung der Zeichnungen**

Die Zeichnungen veranschaulichen die Erfindung anhand eines Ausführungsbeispiels, und zwar zeigt:

Figur 1     ein Diagramm mit Phasenstromverläufen die Sprungstellen aufweisen,

Figur 2     ein Diagramm mit korrigierten Phasenstromverläufen,

Figur 3     einen rotierenden Phasenvektor,

Figur 4     einen rotierenden Phasenvektor der Sprungstellen aufweist,

Figur 5     einen rotierenden Phasenvektor mit einer Zusammensetzung der Sprungstellen,

Figur 6     eine schematische Darstellung des erfindungsgemäßen Verfahrens,

Figur 7     eine Ermittlung der von dem Messstromverlauf abzuziehenden Stromwerte mit einer Regelung.

**Ausführungsform(en) der Erfindung**

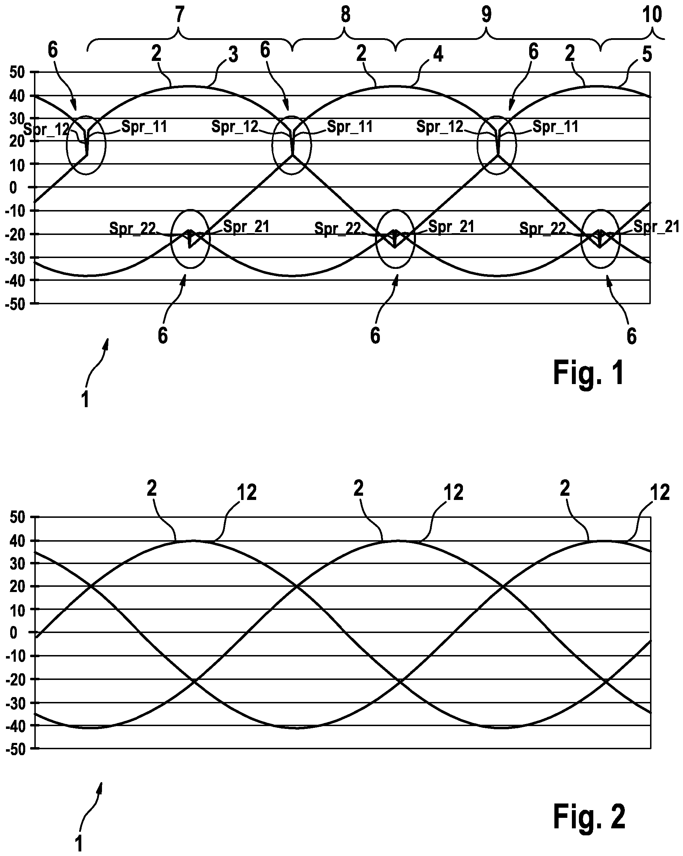

Die Figur 1 zeigt ein Diagramm 1, welches drei Phasenstromverläufe 2 darstellt, die aus nicht dargestellten Messstromverläufen ermittelt wurden. Die Phasenstromverläufe 2 sind einem nicht dargestellten Stromnetz zugeordnet, das drei Phasen U, V und W aufweist, welche jeweils einen der Ströme I'_U, I'_V und I'_W führen. Dabei entspricht ein erster Phasenstromverlauf 3 dem Verlauf des Stromes I'_U, ein zweiter Phasenstromverlauf 4 dem Verlauf des Stroms I'_V und ein dritter Phasenstromverlauf 5 dem Verlauf des Stroms I'_W. Für die Ermittlung der Phasenstromverläufe 2 wurden im Stromnetz zwei Messstromverläufe gemessen, welche die Verläufe der Ströme I1_gem und I2_gem beschreiben. Die Phasenstromverläufe 2 weisen Sprungstellen 6 auf, wobei Ausgestaltungen der Sprungstellen 6 sich zwischen den Phasenstromverläufen 2 gleichen. Innerhalb eines jeden Phasenstromverlaufs 2 sind vier unterschiedliche Sprünge Spr_11, Spr_12, Spr_21 und Spr_22 angeordnet. Der Sprung Spr_11 führt am Beispiel des Phasenstromverlaufs 3 zu einem Anstieg für einen Zeitabschnitt 7. Der Sprung Spr_12 führt zu einem Abfall des Phasenstromverlaufs 3 für einen Zeitabschnitt 8, wobei der Sprung Spr_12 die gleiche Sprunghöhe aufweist wie der Sprung Spr_11. Der Sprung Spr_21 führt zu einem erneuten Anstieg des Phasenstromverlaufs 3, wobei der erneute Anstieg kleiner ist als der Anstieg des Sprungs Spr_21, wobei der entstehende Anstieg für einen Zeitabschnitt 9 gilt. Die Sprunghöhen sind dabei nicht auf die dargestellten Höhen und Verhältnisse beschränkt. Im weiteren Verlauf des Phasenstromverlaufs 3 zeigt sich der Sprung Spr_22, welcher den Phasenstromverlauf 3 für den Zeitabschnitt 10 absenkt, wobei die Sprünge Spr_21 und Spr_22 die gleiche Sprunghöhe aufweisen. Die Abfolge dieser Sprünge Spr_11, Spr_12, Spr_21 und Spr_22 erfolgt periodisch und ist für alle Phasenstromverläufe 2 gleich, wobei eine entsprechende zeitliche Verschiebung zwischen den Phasenstromverläufen 2 zu berücksichtigen ist.

Die Figur 2 zeigt das Diagramm 1 mit korrigierten Phasenstromverläufen 2, welche Sinusstromverläufe 12 sind. Um die korrigierten Phasenstromverläufe 2 zu erhalten, wurden die einzelnen Abschnitte der mit Sprungstellen 6 behafteten Phasenstromverläufe 2 aus der Figur 1, wie am Beispiel des Phasenstromverlaufs 3 in den Zeitabschnitten 7, 8, 9 und 10 entlang der Sprünge Spr_11, Spr_12, Spr_21 und Spr_22 um einen Teil der ihnen zugeordneten Sprunghöhen verschoben.

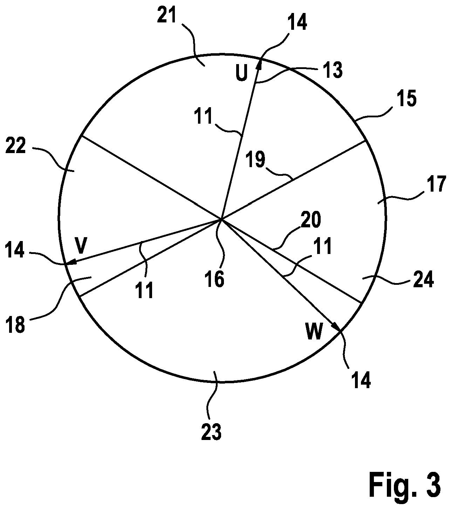

Die Figur 3 zeigt einen rotierenden Phasenvektor 13, welcher die drei Phasen U, V und W des Stromnetzes darstellt. Als Phasenvektor 13 kann beispielsweise ein Spannungsvektor dienen, der über eine weitere, zusätzliche Messung im Stromnetz oder aus einer Steuerung für das Stromnetz heraus bekannt ist. Der Phasenvektor 13 rotiert in Gegenuhrzeigerrichtung. Der rotierende Phasenvektor 13 weist drei Phasenvektoräste 11 auf, wobei jeder Phasenvektorast 11 einer Phase U, V oder W zugeordnet ist, ferner sind die Phasenvektoräste 11 in einem Winkel von 120° zueinander angeordnet und verlaufen alle mit einer Spitze 14 auf einer kreisförmigen Umlaufbahn 15 um den Mittelpunkt 16. Zudem verläuft eine horizontale Gerade 17 durch den Mittelpunkt 16. Der vertikale Abstand der Spitzen 14 von der Geraden 17 entspricht dem momentanen Stromwert des der Phase U, V oder W zugehörigen Stroms I'_U, I'_V oder I'_W. Der durch die kreisförmige Umlaufbahn 15 umschlossene Kreis 18 ist durch zwei Geraden 19 und 20, welche durch den Mittelpunkt 16 verlaufen, in vier Kreissegmente 21, 22, 23 und 24 unterteilt. Die einzelnen Kreissegmente 21, 22, 23 und 24 bestimmen, auf welche Weise der Phasenstromverlauf 2 ermittelt wird. Liegt einer der Phasenvektoräste 11 im Kreissegment 21, so wird der dem Phasenvektorast 11 zugeordnete Phasenstromverlauf 2 aus dem Messstromverlauf des Stroms I1_gem direkt entnommen. Liegt einer der Phasenvektoräste 11 innerhalb des Kreissegments 22, so wird für die entsprechende Phase U, V oder W der Phasenstromverlauf 2 aus den Messstromverläufen der Ströme I1_gem und I2_gem berechnet. Liegt einer der Phasenvektoräste 11 in Segment 23, so wird für die entsprechende Phase U, V oder W der Phasenstromverlauf 2 direkt aus dem Messstromverlauf des Stroms I2_gem entnommen. Liegt einer der Phasenvektoräste 11 in dem Kreissegment 24, so wird für die entsprechende Phase U, V oder W der Phasenstromverlauf 2 anhand der Messstromverläufe I1_gem und I2_gem berechnet. Die in Figur 3 dargestellte Umlaufbahn 15 zeigt eine fehlerfreie Kreisform, woraus sich für die Phasenstromverläufe 2 Sinusstromverläufe 12 ergeben, wie dies in Figur 2 dargestellt ist. Die Lage des rotierenden Phasenvektors 13 und damit die Lage der Phasenvektoräste 11 wird anhand des Drehwinkels des Phasenvektors bestimmt.

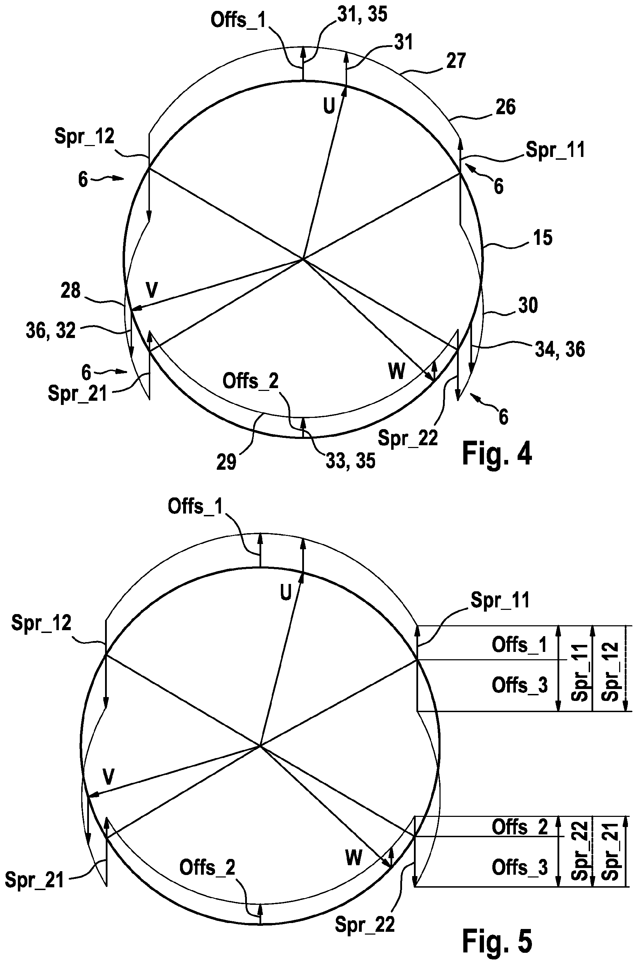

Die Figur 4 zeigt die Darstellung der Figur 3, wobei zusätzlich eine Umlaufbahn 26 dargestellt ist, welche vier Sprungstellen 6 enthält, die die Umlaufbahn in vier Umlaufbahnsegmente 27, 28, 29 und 30 unterteilt. Die Umlaufbahn 26 stellt die Phasenstromverläufe 2 der Figur 1 dar. Somit finden die Sprungstellen 6 ihre Entsprechungen in den Sprüngen Spr_11, Spr_12, Spr_21 und Spr_22. Daraus ergibt sich, dass die Umlaufbahnsegmente 27, 28, 29 und 30 jeweils einem Zeitabschnitt 7, 8, 9 oder 10 der Figur 1 zugeordnet sind. Dabei ist das Umlaufbahnsegment 27 dem Zeitabschnitt 7, das Umlaufbahnsegment 28 dem Zeitabschnitt 8, das Umlaufbahnsegment 29 dem Zeitabschnitt 9 und das Umlaufbahnsegment 30 dem Zeitabschnitt 10 zugeordnet. Die Umlaufbahn 26 zeigt an verschiedenen Stellen gegenüber der Umlaufbahn 15 unterschiedliche Verschiebungen 31, 32, 33 und 34, wobei die Beträge der Verschiebungen 31, 32 und 33 unterschiedlich sind und die Beträge der Verschiebungen 32 und 34 gleich sind. Die Verschiebungen 32 und 34 stellen zudem einen Zusatzfehler 36 dar. Die Verschiebungen 31, 32, 33 und 34 stellen jeweils eine Ungenauigkeit 35 dar, welche in ihrem jeweiligen Umlaufbahnsegment 27, 28, 29 und 30 herrscht. Es ergibt sich somit daraus eine individuelle Parallelverschiebung für jedes Umlaufbahnsegment 27, 28, 29 und 30 gegenüber der Umlaufbahn 15. Bei der gewählten Darstellung wurden reale Fehlerwerte der Ströme I1_gem und I2_gem zugrunde gelegt. Der Stromwert der Verschiebung 31 wird mit Offs_1 bezeichnet, der Stromwert der Verschiebung 33 wird mit Offs_2 bezeichnet und der Stromwert der Verschiebungen 32 und 34 wird mit Offs_3 bezeichnet. Für das in der hier beschriebenen Ausführungsform zugrunde gelegte Stromnetz gilt im Zusammenhang mit den Verschiebungen 31, 32, 33 und 34 folgende elektrische Gleichung, die aus der Knotenregel hergeleitet ist:

$$Offs\_1 + Offs\_2 + Offs\_3 = 0 \qquad (1)$$

Daraus ergibt sich, dass die Sprungstellen 6 dort auftreten, wo ein Phasenvektorast 11 von einem Segment 21, 22, 23 oder 24 in ein anderes Kreissegment 21, 22, 23 oder 24 wechselt. Aufgrund der Anordnung der Kreissegmente 21, 22, 23 und 24 entstehen immer gleichzeitig in zwei verschiedenen Phasen U, V und/oder W jeweils eine Sprungstelle 6, wobei sich die Arten der Sprungstellen 6 zwischen den Phasen U, V oder W voneinander unterscheiden. Insbesondere ergibt sich ein Zusammenhang zwischen gleichzeitig auftretenden Sprungstellen verschiedener Phasen U, V oder W, derart, dass deren Sprunghöhen betragsweise gleich sind, sich jedoch im Vorzeichen unterscheiden.

Die Figur 5 zeigt die Darstellung aus der Figur 4, wobei die Sprünge Spr_11 und Spr_22 im Detail beschrieben sind. Hierbei zeigt sich, dass jeder Sprung Spr_11, Spr_12, Spr_21 und Spr_22 eine Summe von zwei der Verschiebungen 31, 32, 33 und 34 darstellt. Insbesondere ist dargestellt, dass es sich bei den Sprungstellen 6 um eine Summe von zwei Ungenauigkeiten 35 handelt, so genannte Offsets. Ferner wird die Bedeutung der oben genannten Knotenregel deutlich. Aufgrund der Figur 5 lassen sich folgende zwei Gleichungen aufstellen:

$$Spr\_11 = Offs\_1 - Offs\_3 \qquad (2)$$

$$Spr\_21 = Offs\_2 - Offs\_3 \qquad (3)$$

Aus Gleichung (1), Gleichung (2) und Gleichung (3) ergibt sich

$$Spr\_11 = 2 \cdot Offs\_1 + Offs\_2 \qquad (4)$$

und

$$Spr\_21 = Offs\_1 + 2 \cdot Offs\_2 \qquad (5)$$

Dies führt zu zwei Gleichungen mit zwei Unbekannten, aus denen sich die Stromwerte Offs_1 und Offs_2 der Verschiebungen 31 und 33 aus den beiden Sprüngen Spr_11 und Spr_21 wie folgt ergeben:

$$Offs\_2 = \frac{2}{3} \cdot Spr\_21 - \frac{1}{3} \cdot Spr\_11 \qquad (6)$$

$$Offs\_1 = \frac{2}{3} \cdot Spr\_11 - \frac{1}{3} \cdot Spr\_21 \qquad (7)$$

Die in den Messstromverläufen gemessenen Ströme I1_gem und I2_gem können mittels der Stromwerte Offs_1 und Offs_2 der Fehler 35 zu Strömen I1 und I2 wie folgt korrigiert werden:

$$I1 = I1'\_gem - Offs\_1 \qquad (8)$$

$$I2 = I2'\_gem - Offs\_2 \qquad (9)$$

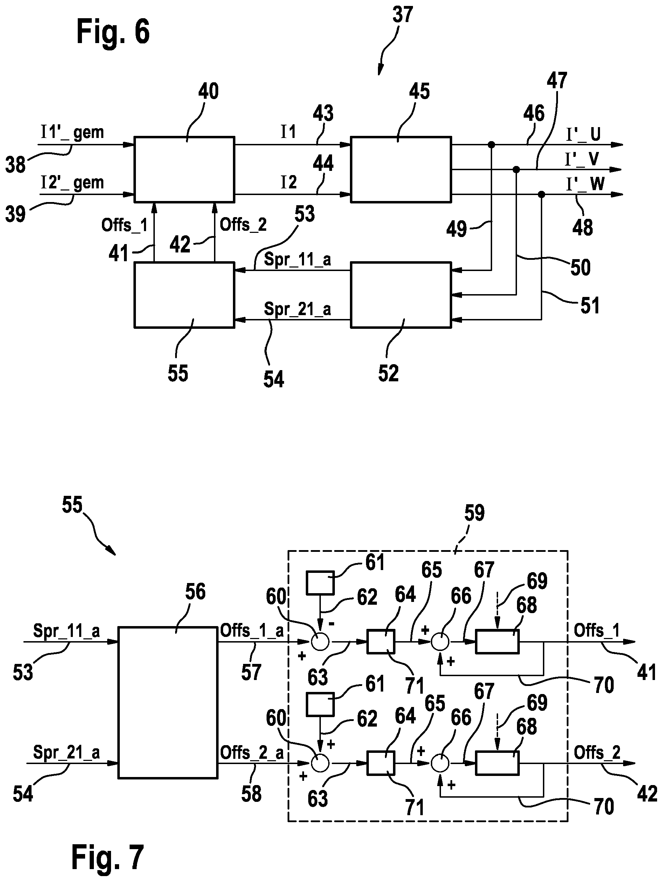

Die Figur 6 zeigt das erfindungsgemäße Verfahren 37, wobei dem Verfahren 37 die gemessenen Ströme I1'_gem und I2'_gem über Pfeile 38 und 39 zugeführt werden. Die Pfeile 38 und 39 münden in einer Korrektureinheit 40, welche korrigierte Ströme I1 und I2 nach den Gleichungen (8) und (9) berechnet. Zu diesem Zweck werden der Korrektureinheit 40 über Pfeile 41 und 42 die Stromwerte Offs_1 und Offs_2 zugeführt. Die korrigierten Strömen I1 und I2 werden über Pfeile 43 und 44 an eine Umrechnungseinheit 45 weitergeleitet, welche die korrigierten Ströme I1 und I2 in die Phasenströme I'_U, I'_V und I'_W umrechnet. Die Umrechnung erfolgt dabei durch das in den Figuren 3 bis 5 erläuterte Verfahren mittels eines rotierenden Phasenvektors 13. Die drei Ströme I'_U, I'_V und I'_W werden über Pfeile 46, 47 und 48 zur weiteren Analyse und Bearbeitung zur Verfügung gestellt. Ausgehend von den Pfeilen 46, 47 und 48 geht jeweils ein Pfeil 49, 50 und 51 ab, welche die Ströme I'_U, I'_V und I'_W an eine Sprungermittlung 52 weiterleiten. Die Sprungermittlung 52 analysiert die Phasenstromverläufe 2, welche von den Strömen I'_U, I'_V und I'_W gebildet werden und gibt zum Zeitpunkt einer Sprungstelle 6 die aktuellen Sprünge Spr_11_a und Spr_21_a und deren Sprunghöhe über Pfeile 53 und 54 an eine Fehlerermittlung 55 - auch als Offsetermittlung bezeichnet - weiter. Die Fehlerermittlung 55 berechnet die Stromwerte Offs_1 und Offs_2, welche wieder über die Pfeile 41 und 42 an die Korrektureinheit 40 übergeben werden. Da die Zeitpunkte potentieller Sprungstellen 6 durch den rotierenden Phasenvektor 13 bekannt sind, können zu exakt diesem Zeitpunkt auch die entsprechenden Stromwerte der Sprunghöhen der Sprünge Spr_11_a beziehungsweise Spr_21_a gemessen und ausgewertet werden. Bei alledem ist zu beachten, dass immer einer der drei Ströme I'_U, I'_V oder I'_W mit Hilfe der Knotenregel berechnet werden muss. Schließlich führt diese Methode zu einem kontinuierlichen Sinusstromverlauf 12 für die Ströme I'_U, I'_V und I'_W der Phasen U, V und W.

Die Figur 7 zeigt eine Detailansicht der Fehlerermittlung 55 aus Figur 6. Dabei weist die Fehlerermittlung 55 eine Fehlerberechnung 56 auf, welche Stromwerte Offs_1_a und Offs_2_a mittels Pfeilen 57 und 58 an einen Fehlerregler 59 weiterleitet. Die Stromwerte Offs_1_a und Offs_2_a werden einem Subtrahierer 60 zugeführt, welchem ein Sollwert 61 über einen Pfeil 62 zugeführt wird. Der Sollwert 61 beträgt Null. Das Ergebnis des Subtrahierers 60 wird mittels eines Pfeils 63 an ein Verstärkungsglied 64 weitergeleitet, welcher das verstärkte Signal über einen Pfeil 65 an einen Addierer 66 überträgt. Das Ergebnis des Addierers 66 wird über einen Pfeil 67 an ein Verzögerungsglied 68 übergeben, welchem über einen Pfeil 69 zum Zeitpunkt einer Sprungstelle 6 ein Triggersignal gesendet wird, wodurch das Verzögerungsglied weitergeschaltet wird. Das Ergebnis des Verzögerungsglieds 68 entspricht jeweils den Stromwerten Offs_1 und Offs_2. Über einen Pfeil 70 werden diese Werte an den Summierer 66 zurückgeführt. Die Fehlerberechnung 56 berechnet die Stromwerte Offs_1_a und Offs_2_a anhand der Gleichungen (6) und (7), wobei in diesem Fall Offs_1 durch Offs_1_a und Offs_2 durch Offs_2_a in den Gleichungen ersetzt werden. Diese Werte werden zunächst im Subtrahierer 60 mit einem Sollwert 61 beaufschlagt und anschließend in dem Verstärker 64 verstärkt. Der Verstärker 64 dient somit als P-Glied 71 des Fehlerreglers 59. Das Verzögerungsglied 68 ergibt zusammen mit dem Summierer 66 ein I-Glied 72 des Fehlerreglers 59, welches bei jeder Sprungstelle 6 integriert, wenn dem I-Glied über den Pfeil 69 das Triggersignal übermittelt wird. Bezogen auf eine elektrische Periode des Phasenvektors 13 treten für die Ströme I'_U, I'_V und I'_W der Phasenstromverläufe 2 jeweils die Sprünge Spr_11, Spr_12, Spr_21 und Spr_22 auf. Wie in Figur 1 dargelegt, bilden sie jeweils Paare gleicher Sprunghöhen. Daher wurden für die hier angelegten Betrachtungen lediglich die Sprünge Spr_11 und Spr_21 ausgewählt. Dies bedeutet allerdings, dass während einer elektrischen Periode einer Phase zweimal die Sprünge Spr_11 und zweimal die Sprünge Spr_21 auftreten, wie dies ausführlich in Figur 1 dargestellt ist. Die Tatsache, dass eine entsprechende Information über die jeweiligen Sprungstellen 6 in hoher Häufigkeit vorhanden sind, ermöglicht es, die Korrektur kontinuierlich vorzunehmen. Hierfür bietet sich der oben beschriebene Fehlerregler 59 an. Bei jeder potentiellen Sprungstelle 6 (Spr_11_a und Spr_21_a) wird der Fehlerregler 59 mit den aktuell ermittelten Stromwerten Offs_1_a und Offs_2_a der Fehler 35 gespeist. Mit Hilfe der P-Glieder kann ein Nachregeln der Stromwerte Offs_1 und Offs_2 dosiert werden. Ein Verlauf der Stromwerte Offs_1 und Offs_2 an den Pfeilen 41 und 42 entspricht somit, zumindest bereichsweise, einem PT1-Verhalten.

Mit dieser Methode ist es möglich, Fehler und Sprungstellen bei einer Strommessung, insbesondere mit rotierendem Phasenvektor 13 adaptiv nachzuregeln. Damit können entsprechende Abgleichschritte bei einer Produktion entfallen. Außerdem kann die Qualität der Strommessung über Lebensdauer und Temperatur entsprechender Bauteile verbessert werden, die das Verfahren verwenden. Einschränkungen des zulässigen Toleranzbereiches für einen Bandende-Abgleich um Lebenszeitdriften zu berücksichtigen, wären ferner nicht mehr notwendig. Dadurch kann unter Umständen eine Ausschlussrate in Produktionen reduziert werden.

**Patentansprüche**

1. Verfahren zur Strommessung von Phasenströmen mittels einer Messschaltung in einem mehrphasigen Stromnetz, in dem durch mindestens ein steuerbares Schaltelement eine gewünschte Bestromung mindestens eines elektrischen Verbrauchers erfolgt und auf das Schaltelement Steuersignale wirken, um die gewünschte Bestromung des Verbrauchers zu erreichen, wobei Taktmustern der Ansteuersignale Messfenster für die Strommessung zugeordnet sind und Taktmuster für eine gewünschte Messfenstergröße und/oder -position zueinander zeitlich verschoben werden, wobei bei der Strommessung mindestens ein Stromwerte aufweisender Messstromverlauf gemessen wird, der aufgrund der verschobenen Taktmuster mindestens einen Fehler aufweist, wobei aus dem Messstromverlauf ein Stromwerte aufweisender Phasenstromverlauf (2) ermittelt wird, bei dem der Fehler mindestens eine Sprungstelle bewirkt, wobei das Auftreten der Sprungstelle (6) erfasst wird, die Sprunghöhe der Sprungstelle (6) ermittelt wird und der Phasenstromverlauf (2) in Abhängigkeit der Sprunghöhe derart korrigiert wird, dass der der Sprunghöhe entsprechende Stromwert im sich an die Sprungstelle (6) anschließenden zeitlichen Verlauf von den Stromwerten des Messstromverlaufs abgezogen oder zu diesen addiert wird, **dadurch gekennzeichnet, dass** das Stromnetz einen rotierenden Phasenvektor (13) aufweist und dass aus dem Messstromverlauf der Phasenstromverlauf (2) ermittelt wird, indem die Stromwerte des Phasenstromverlaufs (2) in Abhängigkeit eines Drehwinkels des Phasenvektors (13) dem Messstromverlauf direkt entnommen werden und/oder aus Stromwerten mindestens eines Messstromverlaufs berechnet werden, wobei der Drehwinkel des Phasenvektors (13) in Bereiche eingeteilt wird, in welchen der Phasenstromverlauf (2) auf unterschiedliche Weise aus dem Messstromverlauf ermittelt wird, so dass eine Sprungstelle (6) immer dann auftritt, wenn ein Übergang von einem Drehwinkelbereich in einen anderen Drehwinkelbereich vollzogen wird.

2. Verfahren nach Anspruch 1, **dadurch gekennzeichnet, dass** das Auftreten der Sprungstelle (6) erfasst wird, wenn innerhalb einer festgelegten Zeitspanne ein Anstieg und/oder ein Abfall der Stromwerte des Phasenstromverlaufs (2) einen vorgegebenen Schwellwert über- oder unterschreitet.

3. Verfahren nach Anspruch 1 und/oder 2, **dadurch gekennzeichnet, dass** das Auftreten der Sprungstelle (6) erfasst wird, wenn eine Abweichung des Phasenstromverlaufs (2) von einem berechneten und/oder abgeschätzten erwarteten Phasenstromverlauf (2) auftritt und die Abweichung einen Schwellwert über- oder unterschreitet.

4. Verfahren nach einem der vorhergehenden Ansprüche, **dadurch gekennzeichnet, dass** der Messstromverlauf aufgrund von mindestens einem Bauteilestreuungs-, Temperatur- und/oder Alterungseffekt der Messschaltung mindestens einen über den Messstromverlauf weitgehend gleichförmigen Zusatzfehler (36) aufweist, der im Phasenstromverlauf (2) eine Veränderung der Sprunghöhe der Sprungstelle bewirkt, wobei mittels elektrischer Gleichungen des elektrischen Verbrauchers, insbesondere elektrische Maschinengleichungen einer den elektrischen Verbraucher darstellenden elektrischen Maschine, und der Sprunghöhe der Stromwert der Veränderung berechnet wird, welcher von dem Messstromverlauf abgezogen oder zu diesem addiert wird.

5. Verfahren nach einem der vorhergehenden Ansprüche, **dadurch gekennzeichnet, dass** der der Sprunghöhe entsprechende Stromwert und/oder der der Veränderung der Sprunghöhe entsprechende Stromwert des Phasenstromverlaufs (2) von dem Messstromverlauf in einem bis zu einer weiteren, nachfolgen den Sprungstelle (6) reichenden Zeitabschnitt unverändert abgezogen oder zum Messstromverlauf unverändert addiert wird/werden.

**Claims**

1. Method for current measurement of phase currents by means of a measurement circuit in a multiphase power supply system, in which at least one electrical load is energized in a desired manner by at least one controllable switching element and control signals act on the switching element in order to achieve the desired energization of the load, wherein clock patterns of the drive signals are assigned measurement windows for the current measurement and clock patterns for a desired measurement window variable and/or position are temporally shifted with respect to one another, wherein, in the current measurement, at least one measurement current profile having current values is measured, said measurement current profile having at least one error on account of the shifted clock patterns, wherein a phase current profile (2) having current values is determined from the measurement current profile, in which phase current profile the error causes at least one discontinuity, wherein the occurrence of the discontinuity (6) is detected, the step height of the discontinuity (6) is determined and the phase current profile (2) is corrected depending on the step height in such a way that, in the time profile following the discontinuity (6), the current value that corresponds to the step height is subtracted from or added to the current values of the measurement current profile, **characterized in that** the power supply system has a rotating phase vector (13) and **in that** the phase current profile (2) is determined from the measurement current profile by virtue of the current values of the phase current profile (2) being taken directly from the measurement current profile depending on a rotation angle of the phase vector (13) and/or being calculated from current values of at least one measurement current profile, wherein the rotation angle of the phase vector (13) is divided into regions in which the phase current profile (2) is determined from the measurement current profile in different ways so that a discontinuity (6) always occurs when there is a transition from one rotation angle range to another rotation angle range.

2. Method according to Claim 1, **characterized in that** the occurrence of the discontinuity (6) is detected when a rise and/or a fall of the current values of the phase current profile (2) exceeds or undershoots a prescribed threshold value within a predetermined period.

3. Method according to Claim 1 and/or 2, **characterized in that** the occurrence of the discontinuity (6) is detected when a deviation of the phase current profile (2) from a calculated and/or estimated expected phase current profile (2) occurs and the deviation exceeds or undershoots a threshold value.

4. Method according to one of the preceding claims, **characterized in that** the measurement current profile has at least one additional error (36) on account of at least one component scattering, temperature and/or ageing effect of the measurement circuit, which additional error is substantially uniform over the measurement current profile and causes a change in the step height of the discontinuity in the phase current profile (2), wherein the current value of the change is calculated by means of electrical equations of the electrical load, in particular electrical machine equations of an electric machine constituting the electrical load, and the step height, said current value being subtracted from or added to the measurement current profile.

5. Method according to one of the preceding claims, **characterized in that** the current value that corresponds to the step height and/or the current value of the phase current profile (2) that corresponds to the change in step height is/are subtracted in unchanged form from the measurement current profile or is/are added in unchanged form to the measurement current profile in a period of time reaching up to a further subsequent discontinuity (6).

**Revendications**

1. Procédé de mesure du courant de courants de phase au moyen d'un circuit de mesure dans un réseau électrique multiphasé, dans lequel une mise sous tension souhaitée d'au moins un récepteur électrique est effectuée par au moins un élément de commutation commandable et des signaux de commande agissent sur l'élément de commutation afin d'obtenir la mise sous tension souhaitée du récepteur, des fenêtres de mesure pour la mesure du courant étant associées aux modèles de cycle des signaux d'attaque et les modèles de cycle étant décalés dans le temps les uns par rapport aux autres pour une taille et/ou une position de fenêtre de mesure souhaitée, au moins une courbe de courant de mesure présentant des valeurs de courant étant mesurée lors de la mesure du courant, laquelle présente au moins une erreur en raison du modèle de cycle décalé, une courbe de courant de phase (2) présentant des valeurs de courant étant déterminée à partir de la courbe de courant de mesure, avec laquelle l'erreur provoque au moins un point de saut, la survenance du point de saut (6) étant détectée, la hauteur de saut du point de saut (6) étant déterminée et la courbe de courant de phase (2) étant corrigée en fonction de la hauteur de saut de telle sorte que la valeur de courant correspondant à la hauteur de saut est soustraite des valeurs du courant de la courbe de courant de mesure ou y est ajoutée dans la courbe dans le temps qui se rattache au point de saut (6), **caractérisé en ce que** le réseau électrique présente un vecteur de phase tournant (13) et **en ce que** la courbe de courant de phase (2) est déterminée à partir de la courbe de courant de mesure par le fait que les valeurs du courant de la courbe de courant de phase (2) sont prélevées directement de la courbe de courant de mesure en fonction d'un angle de rotation du vecteur de phase (13) et/ou sont calculées à partir de valeurs de courant d'au moins une courbe de courant de mesure, l'angle de rotation du vecteur de phase (13) étant divisé en plages dans lesquelles la courbe de courant de phase (2) est déterminée de différentes manières à partir de la courbe de courant de mesure, de sorte qu'un point de saut (6) se produit toujours lorsqu'une transition d'une plage d'angles de rotation dans une autre plage d'angles de rotation est accomplie.

2. Procédé selon la revendication 1, **caractérisé en ce que** la survenance du point de saut (6) est détectée si, à l'intérieur d'un intervalle de temps donné, une croissance et/ou une chute des valeurs de courant de la courbe de courant de phase (2) franchit une valeur de seuil prédéfinie vers le haut ou vers le bas.

3. Procédé selon la revendication 1 et/ou 2, **caractérisé en ce que** la survenance du point de saut (6) est détectée lorsqu'il se produit un écart de la courbe de courant de phase (2) par rapport à une courbe de courant de phase (2) attendue calculée et/ou estimée et l'écart franchit une valeur de seuil prédéfinie vers le haut ou vers le bas.

4. Procédé selon l'une des revendications précédentes, **caractérisé en ce que** la courbe de courant de mesure présente au moins une erreur supplémentaire (36) sensiblement de même forme sur l'étendue de la courbe de courant de mesure en raison d'au moins un effet de dispersion des composants, de température et/ou de vieillissement, lequel provoque une modification de la hauteur de saut du point de saut dans la courbe de courant de phase (2), la valeur de courant de la modification étant calculée au moyen d'équations électriques du récepteur électrique, notamment d'équations de machine électrique d'une machine électrique représentant les récepteurs électriques, et de la hauteur de saut, ladite modification étant soustraite de la courbe de courant de mesure ou ajoutée à celle-ci.

5. Procédé selon l'une des revendications précédentes, **caractérisé en ce que** la valeur du courant correspondant à la hauteur de saut et/ou la valeur de courant de la courbe de courant de phase (2) correspondant à la modification de la hauteur de saut est soustraite inchangée de la courbe de courant de mesure ou ajoutée inchangée à la courbe de courant de mesure dans une portion de temps qui s'étend jusqu'à un point de saut (6) supplémentaire suivant.

Fig. 1

Fig. 2

Fig. 3

Fig. 4

Fig. 5

## Fig. 6

## Fig. 7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 2004169488 A1